Europäisches Patentamt

European Patent Office

Office européen des brevets

(19)

(11) **EP 1 517 439 A1**

(12) **EUROPEAN PATENT APPLICATION**

(43) Date of publication:
**23.03.2005 Bulletin 2005/12**

(51) Int Cl.7: **H03F 3/45**, H03F 1/08,
H03F 1/32

(21) Application number: **03425600.8**

(22) Date of filing: **16.09.2003**

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(71) Applicant: **STMicroelectronics S.r.l.
20041 Agrate Brianza (Milano) (IT)**

(72) Inventor: **Gramegna, Giuseppe
95100 Catania (IT)**

(74) Representative: **Mittler, Enrico et al
Mittler & C. s.r.l.,
Viale Lombardia, 20
20131 Milano (IT)**

(54) **Transistor amplifier**

(57)    An amplifier comprising at least one amplifier stage (100) is described; the stage (100) includes at least a first transistor (Q1) which has a first input signal (Vi) at a first input terminal and has a first output terminal (Out1) at which a first output amplified signal is present. The first transistor (Q1) comprises a first parasitic capacitive element (Cμ) which is arranged between the first input and output (Out1) terminals and through which a first current (Im1) flows. The stage (100) comprises a device (1) having a second output terminal (Out2) with an output signal having a value equal to but of different sign from the first output signal and it comprises at least one element (2) which is arranged between the first input terminal of the first transistor (Q1) and the second output terminal (Out2) of the device (1) and which is passed through by a second current (Im2) having a value equal to but of different sign from the first current (Im1).

Fig.2

EP 1 517 439 A1

**Description**

The present invention relates to a transistor amplifier.

The actual amplifiers are generally composed by MOS or bipolar transistors in the respective common source and common emitter configurations. In such a way, in fact, said transistors amplify the input signal present at the gate terminal or at the base terminal.

However said transistors are affected by parasitic capacities that change the frequency response performances as the capacity Cgd arranged between the drain and gate terminals of the MOS transistor and the capacity $C\mu$ arranged between the collector and base terminal of the bipolar transistor. Said capacities, even if they have a low value, for the Miller effect can bring into a high distortion of the output signal of the respective transistor.

Low noise amplifier better known as LNA (Low Noise Amplifiers) are presently produced which must satisfy the requirements of a high gain, of a low noise and of a high linearity; in addition, in the case of use in mobile appliances, for example notebooks, said amplifiers must satisfy the requirement of a low consumption.

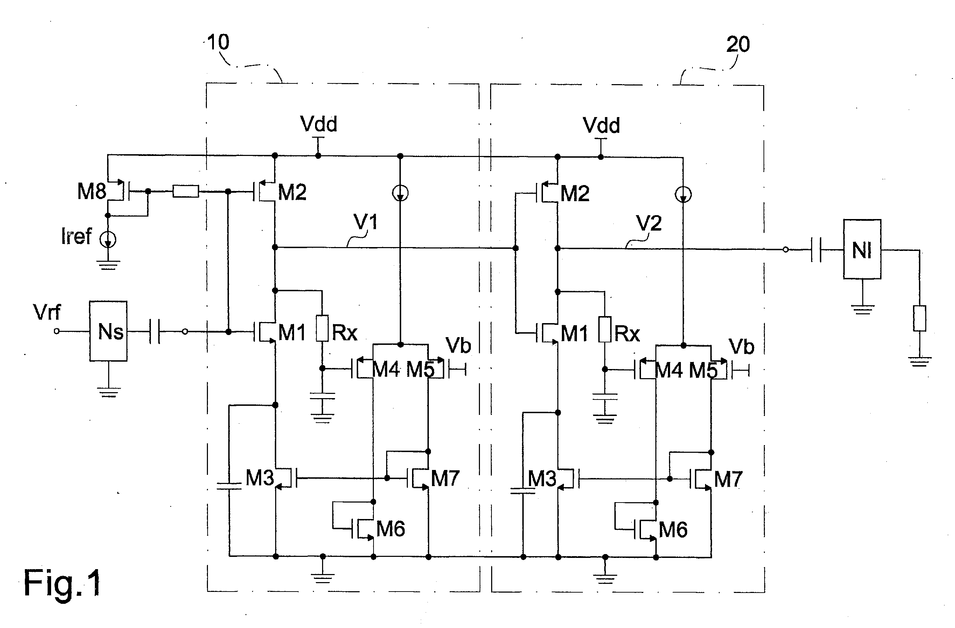

A LNA amplifier is disclosed in the US patent 5721500 and is shown in Figure 1. The amplifier comprises two transconductance amplification stages 10 and 20 which are connected in series with each other. The two stages function in a similar manner and have similar components. The first stage 10 has a transconductance gain Gm given by Gm1+Gm2 where Gmland Gm2 are the transconductance gains of the respective transistors M1 and M2. The drain current of the transistor M1 is re-used in the transistor M2, the transconductance Gm increases without increasing the current consumption. The transistors M3-M7 make a bias current flow in the transistors M1 and M2 and the value of said bias current is fixed by means of the current reference Iref and by means of the current mirror M8-M2. There is even a low-pass filter that is composed by a resistance Rx and a capacitor Cx. The elements Ns and N1 bring the value of the resistance at the input and output terminals to 50 $\Omega$ for inputting and outputting a radio frequency signal. The transistors M1 and M2 have the same bias voltage and a bias voltage Vb is at the gate terminals of the transistors M5. The output voltage V1 of the first stage 10 is in input to the second stage 20; the output voltage V2 of the second stage is the output voltage of the amplifier.

The circuit in Figure 1 has the drawback of a frequency band reduction given by the Miller effect on the capacity Cgd of the transistor M1. A solution for solving the aforementioned drawback consists of introducing a cascode stage for reducing the Miller effect; this causes however the application of a higher supply voltage.

In view of the art described, it is an object to present invention to provide a transistor amplifier that solves the problem of the frequency band reduction without applying a higher supply voltage.

According to the present invention, this object is obtained by means of an amplifier comprising at least one amplifier stage, said stage including at least a first transistor which has a first input signal at a first input terminal and has a first output terminal at which a first output amplified signal is present, said first transistor comprising a first parasitic capacitive element which is arranged between the first input and output terminals and through which a first current flows, said stage comprising a device having a second output terminal with an output signal having a value equal to but of different sign from the first output signal, characterized by comprising at least one element which is arranged between said first input terminal of the first transistor and said second output terminal of the device and which is passed through by a second current having a value equal to but of different sign from said first current.

The features and the advantages of the present invention will be made evident by the following detailed description of embodiments thereof, shown as not limiting examples in the annexed drawings, wherein:

Figure 1 is a scheme of a LNA amplifier according to prior art;
Figure 2 shows a circuit scheme of an amplifier according to present invention;
Figure 3 shown a circuit scheme of the amplifier according to a first embodiment of the present invention;
Figure 4 shown a circuit scheme of the amplifier according to a second embodiment of the present invention;
Figure 5 shows a circuit implementation of the amplifier in Figure 4.

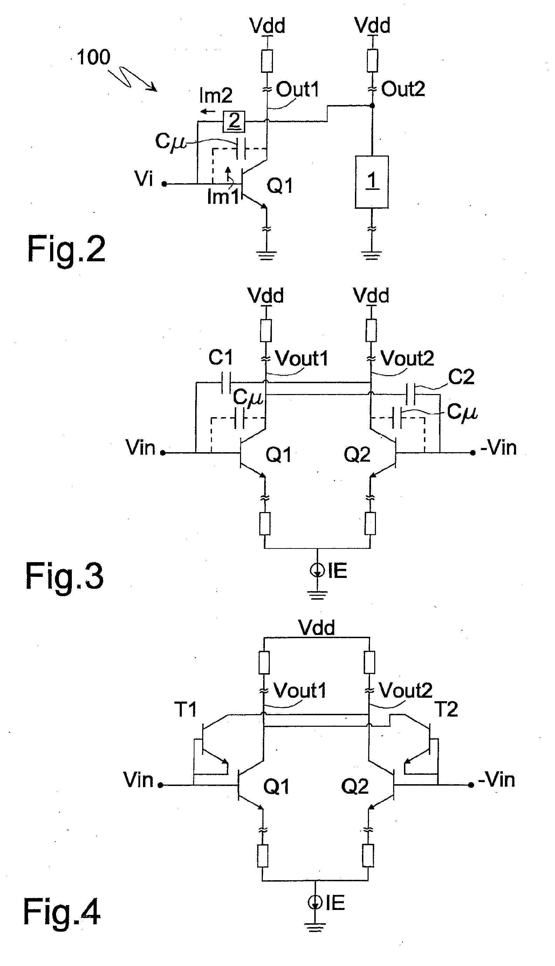

Referring to Figure 2 is shown a scheme of the amplifier according to the present invention. The amplifier in Figure 2 comprises at least one amplifier stage 100 including a transistor Q1 that has an input signal Vi at a drivable terminal and an output terminal Out1 where an amplified output signal Vout1 finds. The transistor Q1 comprises a parasitic capacitive element arranged between the input terminal and output terminal Out1; said parasitic capacitive element, because the transistor Q1 is schematized in Figure 2 as a bipolar transistor, is constituted by the capacity $C\mu$ while if said transistor Q1 were schematized as a MOS transistor, the parasitic capacitive element would be the capacity Cgd. A first current signal Im1 flows through the capacity $C\mu$.

The amplifier stage 100 comprises a device 1, preferably an amplifier device, which has a second output terminal Out2 with an output signal Vout2 having a value equal to but of different sign from the first output signal Vout1.

The amplifier stage 100 comprises an element 2 arranged between the input terminal Vi of the transistor Q and the output terminal Out2 of the amplifier device 1; said element 2 is gone through by a current Im2 having a value substantially equal to but of different sign with respect to the current Iml. A supply voltage Vdd provides to supply the transistor Q1 and the device 1.

Without the element 2 all the capacity seen from the input of the bipolar transistor Q2 for the Miller effect is given by $C\pi+(G-1)*C\mu$ where $C\pi$ is the capacity between the base and emitter terminals and $(G-1)*C\mu$ is the capacitive contribution given by the Miller effect where $C\mu$ is the capacity between the collector and base terminals and G is the voltage gain of the transistor Q1 wherein $Vout1=-G*Vi$. Therefore $C\mu$ is gone through by a current $Im1=s*C\mu*(G-1)*Vi$; for eliminating the Miller effect it is necessary to cancel that current.

With the presence of the element 2, by regarding that

$Vout2=-Voutl=G*Vi$ and by supposing that the element 2 is a capacity C1, the current that goes through C1 is $Im2=s*(1-G)*C1*Vi$. If C1 is substantially equal to $C\mu$ it occurs that $Im2=s*(1-G)*C\mu*Vi$ and the sum of the two currents $Im1+Im2=2*s*C\mu*Vi$ so that the Miller effect is eliminated because the capacitive component $(1-G)*C\mu$ is not more any seen from the input of the transistor Q1.

In Figure 3 a circuit scheme of the amplifier in Figure 2 according to a first embodiment of the present invention is shown. The device 1 of the amplifier stage 100 in Figure 2 is formed as a bipolar transistor Q2 that forms with the transistor Q1 a differential pair having respective input voltages Vin e -Vin at the base terminals of the transistors Q1 and Q2. The differential pair Q1-Q2 is biased by means of a current generator IE coupled with the emitter terminals and is supplied by means of a supply voltage Vdd coupled with the collector terminals. Since the device 1 is implemented by the bipolar transistor Q2 even in said transistor Q2 the Miller effect finds and therefore it is necessary to insert another element 2, indicated by a capacity C2 in Figure 3, for eliminating said Miller effect. If the sizes of the transistors Q1 and Q2 are equal, and therefore the parasitic capacities $C\mu$ of the two transistor are equal, the capacity C2 must have a value equal to the capacity C1 and value equal to $C\mu$ for eliminating the Miller effect in the aforementioned way for the amplifier in Figure 2.

In Figure 4 a circuit scheme of the amplifier in Figure 2 according to a second embodiment of the present invention is shown. Said circuit scheme of the second embodiment is similar to that of the first embodiment in Figure 3 from which it is different for the presence of an element 2 of different type with respect to that shown in Figure 3. The element 2 is constituted by a bipolar transistor and, more specifically, two bipolar transistor T1 and T2 of equal size are arranged between the respective input terminals Vin, -Vin and the respective output terminals Vout2, Vout1. The transistors T1 and T2 are in diode connection and specifically they have the base terminal in common with the emitter terminal and connected with the input terminals Vin and -Vin while they have the collector terminals connected respectively with the output terminals Vout2 and Vout1. The transistor T1 and T2 must have entire capacities Ct1 and Ct2 between the respective emitter and collector terminals which are substantially equal to the capacities $C\mu$ of the transistor Q1 and Q2. In such a way the Miller effect on the capacities $C\mu$ of the transistor Q1 and Q2 may be eliminated in the already above mentioned way.

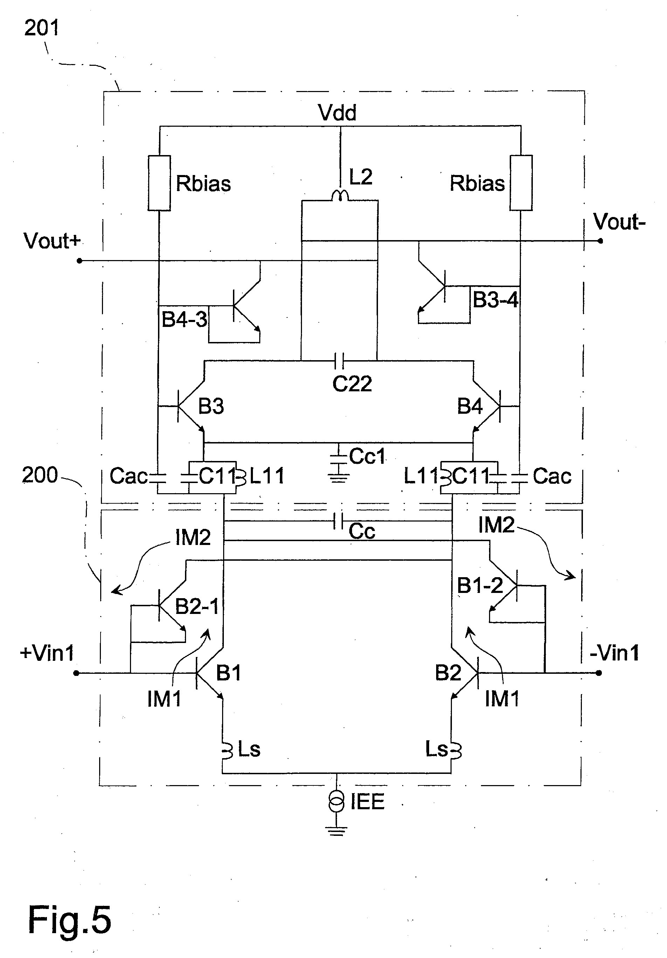

In Figure 5 a circuit implementation of a two stage LNA amplifier according to the second embodiment of the present invention is shown. The amplifier in Figure 1 is formed by a first stage 200 and by a second stage 201. The first stage 200 comprises a differential pair of bipolar transistors B1, B2 which have each one of the emitter terminals connected with an inductance Ls having the other terminal in common to each other and connected with a current generator IEE having the other terminal connected to ground. The voltages Vin1 and -Vin1 are applied at the base terminals of the transistors B1 and B2 and the collector terminals are coupled to each other by means of a capacity Cc. By indicating with G1 the gain of the stage 200 it has an output voltages at the collectors of the transistors B1 and B2 given respectively by $G1*Vin1$ and $-G1*Vin1$.

The stage 201 is coupled in alternated current with the stage 200 by means of two capacities Cac and it uses the same direct current. The stage 201 comprises a second differential pair of transistors B3 and B4 and the two capacities Cac are connected between the collector terminals of the transistors B1 and B2 and the base terminals of the transistors B3 and B4. The block constituted by the inductance L1 parallel to a capacity C11 is connected between each collector terminal of the transistors B1 and B2 and each emitter terminal of the transistors B3 and B4. The emitter terminals of the transistors B3 ad B4 are in common with each other and are coupled to ground by means of a capacity Cc1, the collector terminals are coupled with each other by means of a block given by the inductance L22 parallel to a capacity C22 and the base terminals are coupled with the supply voltage Vdd by means of two resistances Rbias.

By supposing that the Miller effect on the capacities between the base and collector terminal is null, it occurs that the input resistance at the operating frequency fo is given by $Rin(fo)=2\pi*ft*Ls$ where ft is the cut-off frequency of the transistors B1 and B2. The input radio frequency match is obtained at the resonance frequency by making $Rin(fo) = 50\Omega$. In such a condition the gain $G(fo)=Vout/Vin$ where Vout is the output voltage in module at the collectors of the transistors B3 and B4 (the output voltages are Vout+ and Vout- respectively for the transistors B3 and B4) is given by:

$$G(fo) = (ft / fo) * \left( \frac{1}{2Rin(fo)} \right) * G2 * (2\pi fo)^2 * (L11 * Q11) * (L2 * Q2)$$

where L11 and L2 are the load inductances, Q11 and Q12 are their quality factors and G2 is the transconductance gain of the transistor B3 or B4.

By considering even the Miller effect on the capacities between the base and collector terminals of the transistors B1-B4 we will obtain a higher value of the input resistance Rin(fo) and a worsening of the frequency response of the amplifier that has a reduced band, that is a lower cut-off frequency ft; for this reason it is necessary to cancel the Miller effect.

This can be obtained according to invention by placing the bipolar transistors B2-1, B1-2, B3-4, B4-3 respectively between the base terminals of the transistors B1-B4 and the collector terminals of the transistors B2, B1, B4, B3. The transistors B2-1, B1-2, B3-4, B4-3 are in diode connection and have the emitter terminals in common with the base terminals.

Since between the collector and base terminals there is a voltage difference given by (G1-1)Vin1, a current Im1=s*Cμ*(G1-1)*Vin1 will flow through the capacity Cμ of the transistor B1. The addition of the transistor B2-1, which has a total capacity between the emitter and collector terminals equal to the capacity Cμ of the transistor B1 and wherein the voltage difference between the collector and base terminals has equal value to but opposite from that of the transistor B1, allows the injection of a current IM2=-IM1 at the base terminal of the transistor B1; also it results that IM1-IM2=2*s*Cμ*Vin so the Miller effect on the capacity Cμ of the transistor B1 has been cancelled and a total capacity given by Cπ+2Cμ is seen from the input. The transistors B1-2, B3-4 and B4-3 have the same function of the transistor B2-1 that is to cancel the Miller effect on the capacities Cμ of the respective transistors B2, B4 and B3 in the same way already described for the transistor B1.

Amplifiers with more of two stages wherein each or at least one stage is formed according to present invention can be performed.

An additional advantage of said circuit solution for canceling the Miller effect consist of increasing the insulation between the input and the output of the amplifier as compared to the known amplifiers; this makes easier the matching at radio frequency of the input and of the output because the input and output networks can be optimized separately.

**Claims**

1. Amplifier comprising at least one amplifier stage (100, 200, 201), said stage (100, 200, 201) including at least a first transistor (Q1, B1) which has a first input signal (Vi, Vin, Vin1) at a first input terminal and has a first output terminal (Out1) at which a first output amplified signal (Vout1) is present, said first transistor (Q1, B1) comprising a first parasitic capacitive element (Cμ) which is arranged between the first input and output (Out1) terminals and through which a first current (Im1, IM1) flows, said stage (100, 200, 201) comprising a device (1, Q2, B2) having a second output terminal (Out2) with an output signal (Vout2) having a value equal to but of different sign from the first output signal (Vout1), **characterized by** comprising at least one element (C1, T1, B2-1) which is arranged between said first input terminal of the first transistor (Q1, B1) and said second output terminal (Out2) of the device (1, Q2, B2) and which is passed through by a second current (Im2, IM2) having a value equal to but of a different sign form said first current (Im1, IM1).

2. Apparatus according to claim 1, **characterized in that** said at least one element (C1) is a capacitor having a value substantially equal to said first parasitic capacitive element.

3. Apparatus according to claim 1, **characterized in that** said at least one element (T1, B2-1) is another transistor in diode connection which has the input terminal, which corresponds to the drivable terminal, connected to the first input terminal, a non drivable terminal, which corresponds to the output terminal, connected to the second output terminal (Out2) and the other non drivable terminal connected to the input terminal.

4. Apparatus according to claim 3, **characterized in that** said other transistor (T1, B2-1) is a bipolar transistor in diode connection which has the base terminal, which corresponds to the input terminal, in common with the emitter terminal and connected with the first input terminal and the collector terminal, which corresponds to the output terminal, connected with the second output terminal (Out2).

5. Apparatus according to claim 3, **characterized in that** said other transistor (T1, B2-1) is a MOS transistor in diode connection which has the gate terminal, which corresponds to the input terminal, in common with the source terminal and connected with the first input terminal and the drain terminal, which corresponds to the output terminal, connected with the second output terminal (Out2).

6. Apparatus according to claim 3, **characterized in that** said other transistor (T1, B2-1) has a total capacity between its input and output terminals which is substantially equal to said first parasitic capacitive element.

7. Apparatus according to claim 1, **characterized in that** said device is a second transistor (Q2, B2) that in combination with said at least one first transistor (Q1, B1) is adapted to form a differential pair, said second transistor (Q2, B2) having a second input terminal at which an input signal (-Vin, -Vinl) substantially equal to but with a different sign from the said first input signal (Vin, Vin1) finds.

8. Apparatus according to claim 7, **characterized in that** said second transistor (Q2, B2) comprises a second parasitic capacitive element (C$\mu$) which is arranged between the second input and output (Out2) terminals and through which another current flows, said apparatus comprising another element (C2, T2, B1-2) which is arranged between the input terminal of said second transistor (Q2, B2) and said first output terminal (Out1) and which is passed through by a further current having a value substantially to but of different sign from said other current.

9. Apparatus according to claim 8, **characterized in that** said other element (C2) is a capacitor having a value substantially equal to said first parasitic capacitive element.

10. Apparatus according to claim 8, **characterized in that** said other element (T2, B1-2) is a further transistor in diode connection which has the input terminal, which corresponds to the drivable terminal, connected to the second input terminal, a non drivable terminal, which corresponds to the output terminal, connected to the first output terminal (Out2) and the other non drivable terminal connected to the input terminal.

11. Apparatus according to claim 10, **characterized in that** said further transistor (T2, B1-2) has a total capacity between its input and output terminals which is substantially equal to said second parasitic capacitive element.

Fig.1

EP 1 517 439 A1

Vdd    Vdd

100    Im2    Out1    Out2

Cμ    2

Vi    Q1

Im1

# Fig.2

Vdd    Vdd

C1    Vout1    Vout2    C2

Cμ    Cμ

Vin    Q1    Q2    -Vin

IE

# Fig.3

Vdd

Vout1    Vout2

T1    T2

Vin    Q1    Q2    -Vin

IE

# Fig.4

Fig.5

**European Patent Office**

## EUROPEAN SEARCH REPORT

Application Number

EP 03 42 5600

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | CASSAN D J ET AL: "A 1-V TRANSFORMER-FEEDBACK LOW-NOISE AMPLIFIER FOR 5-GHZ WIRELESS LAN IN 0.18-MUM CMOS" IEEE JOURNAL OF SOLID-STATE CIRCUITS, IEEE INC. NEW YORK, US, vol. 38, no. 3, March 2003 (2003-03), pages 427-435, XP001158083 ISSN: 0018-9200 | 1,2,7-9 | H03F3/45 H03F1/08 H03F1/32 |
| Y | * page 427, right-hand column, line 14 - page 428, right-hand column, line 12; figure 2A * | 6,11 | |
| X | FONDERIE J ET AL: "AMPLIFIERS 1-VOLT OPERATIONAL AMPLIFIER WITH RAIL-TO-TAIL INPUT AND OUTPUT RANGES" IEEE INTERNATIONAL SOLID STATE CIRCUITS CONFERENCE, IEEE INC. NEW YORK, US, vol. 32, 1 February 1989 (1989-02-01), pages 64-65,291, XP000066825 ISSN: 0193-6530 | 1,3-5,10 | |
| Y | * page 64, left-hand column, line 6-38; figure 1 * | 6,11 | **TECHNICAL FIELDS SEARCHED** (Int.Cl.7) |
| A | HATANAKA S ET AL: "GAIN-BOOSTED OPERATIONAL AMPLIFIER FOR LOW SUPPLY VOLTAGE" EXTENDED ABSTRACTS OF THE INTERNATIONAL CONFERENCE ON SOLID STATE DEVICES AND MATERIALS, JAPAN SOCIETY OF APPLIED PHYSICS. TOKYO, JA, vol. 2001, 26 September 2001 (2001-09-26), pages 104-105, XP001074515 * page 104, right-hand column, line 15-20 - page 105, left-hand column, line 1-15; figure 5 * | 1-11 | H03F |

The present search report has been drawn up for all claims

| Place of search | Date of completion of the search | Examiner |
|---|---|---|
| THE HAGUE | 6 February 2004 | Fedi, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)